# EUROPEAN PATENT APPLICATION

(11) **EP 2 271 182 A1**
(43) Date of publication of application: **05.01.2011**
(21) Application number: 09728596.9
(22) Date of filing: 11.03.2009
(51) Int. Cl.: H05B 33/10, H01L 51/50, H05B 33/26

(54) **ORGANIC ELECTROLUMINESCENCE ELEMENT AND METHOD FOR MANUFACTURING THE SAME**

(30) Priority: 31.03.2008 JP 2008091744
(71) Applicant: Sumitomo Chemical Company, Limited, Tokyo 104-8260 (JP)
(72) Inventor: MORISHIMA, Shinichi, Tsukuba-shi Ibaraki 305-0047 (JP)
(74) Representative: Duckworth, Timothy John
(86) International application number: PCT/JP2009/054669
(87) International publication number: WO 2009/122876

(57) **Abstract**

An organic electroluminescent element is manufactured by: a step of forming a first electrode layer on a substrate; a step of forming a light-emitting layer above the first electrode layer; a step of forming a charge injection layer above the light-emitting layer; a step of forming a metal layer that includes a material selected from the group consisting of aluminum, silver, tin, copper, and a composite metallic material containing two or more members of these metals above the charge injection layer; and a step of forming a second electrode layer by laminating an electrode material selected from transparent conductive oxides, transparent conductive nitrides, and composite materials of these compounds above the metal layer by a low damage sputtering method, an ion plating method, or a chemical vapor deposition (CVD) method.

## Description

### TECHNICAL FIELD

The present invention relates to a method for manufacturing an organic electroluminescent element (hereinafter, also referred to as an "organic EL element"), and relates to an organic EL element.

### BACKGROUND ART

Various studies of organic EL devices have been performed in which organic electroluminescent elements (hereinafter, also referred to as an "organic EL element") are mounted on the devices so as to develop devices that provide a higher level of performance. Although organic EL elements have various structures, the elements basically include a light-emitting layer that is sandwiched with an anode and cathode. In addition to the development of organic EL elements to improve characteristics such as light-emitting efficiency, durability, and product service life, and those having increased multilayered structures have also been developed. Such organic EL elements with multilayered structures are generally manufactured by a method of stacking each function layer on a substrate in order.

Each layer is formed in a thin film, and therefore, various thin film-forming methods can be employed as a forming method of each layer. For example, the sputtering method is employed as a forming method of each layer of an organic EL element. The sputtering method has advantages: a film with strong adhesion to the substrate can be produced; and thin films made of a substance with a high melting point, or made of oxides or nitrides can be formed, for example. However, when the sputtering method is employed, damage to layers previously provided, such as a light-emitting layer, is a concern. Damaging factors such as high-energy particles (charged particles, accelerated neutral particles, plasma), light, and active oxygen are considered as factors affecting a substrate in the sputtering process.

For this reason, a technique to-further alleviate damage to the other layers during layer formation is required. For a technique to devise sputtering apparatuses and processes thereof, for example, disclosed is a method of preventing irradiation of high-energy particles that are damaging factors to a substrate by biasing a substrate holder (for example, Patent Document 1). Other methods include the facing-target sputtering method in which the - target for sputtering is placed perpendicular to a substrate so as to trap plasma (for example, Patent Documents 2 and 3). Moreover, disclosed is a method of employing a plurality of buffer layers by-which damaging factors are blocked before reaching an organic light-emitting layer so as not to affect the light-emitting layer (Patent Documents 4 and 5), for example.

Patent Document 1: JP 2005-142079 A
Patent Document 2: JP H10-46330 A
Patent Document 3: JP H10-330936 A
Patent Document 4: JP 2002-260862 A
Patent Document 5: JP 2006-66553 A

### DISCLOSURE OF INVENTION

### PROBLEM TO BE SOLVED BY THE INVENTION

However, conventional methods cannot completely prevent the incidence of high-energy particles that are damaging factors to a substrate, and thus damage to a previously formed layer, especially, to a light-emitting layer, cannot be fully excised. In addition, providing a buffer layer needed to be formed from multiple layers complicates not only the process but also the structures of organic EL elements in their role as products.

Although the thickness of each layer depends on the type of each layer that constitutes an organic EL element, the thickness is extremely-small ranging from a few nanometers to about 1 mm. Therefore, a technique to further suppress damage during layer formation is desired. Particularly, when the light-emitting layer is damaged, the organic EL element might undergo a decrease in brightness, decrease in light-emitting efficiency, increase in driving voltage, or similar effect. Given such conditions, an object of the present invention is to provide a method for manufacturing an organic EL element, which hardly gives damages to a previously formed-layer during layer formation of the organic EL element. Another object of the present invention is to provide an organic EL element with a structure that cannot readily be damaged during the layer-forming process.

### MEANS FOR SOLVING PROBLEM

The present inventors have made extensive and intensive studies regarding methods of forming layers that constitute an organic EL element. As a result, the inventors have found that the objects described above can be met by a simple method of providing a predetermined metal layer before an electrode material and the like are stacked by a method such as sputtering. That is, the present invention provides a method for manufacturing an organic EL element and an organic EL element obtained by the method for manufacturing that are described below.

[1] A method for manufacturing an organic electroluminescent element in which at least a first electrode layer, a light-emitting layer comprising a macromolecular organic compound, and a second electrode layer are stacked on a substrate, the method comprising the steps of:
   forming the first electrode layer above the substrate;
   forming the light-emitting layer above the first electrode layer;
   forming a charge injection layer above the light-emitting layer;
   forming a metal layer comprising a material selected from the group consisting of aluminum, silver, tin, copper, and composite metallic materials comprising two or more members of these metals above the charge injection layer; and
   forming the second electrode layer by stacking an electrode material selected from among transparent conductive oxides, transparent conductive nitrides, and composite materials of these compounds above the metal layer by a low damage sputtering method, an ion plating method, or a chemical vapor deposition (CVD) method.
[2] The method for manufacturing an organic electroluminescent element according to the above [1], wherein the metal layer is formed directly on the charge injection layer provided above the light-emitting layer, and the second electrode layer is formed directly on the metal layer.
[3] The method for manufacturing an organic electroluminescent element according to the above [1], wherein the metal layer is formed to have a thickness of from 0.5 nm to 30 nm.
[4] The method for manufacturing an organic electroluminescent element according to the above [1], wherein the metal layer is formed by a vacuum deposition method.
[5] The method for manufacturing an organic electroluminescent element according to the above [1], wherein the low damage sputtering method is a facing-target sputtering method or an ion beam sputtering method.
[6] The method for manufacturing an organic electroluminescent element according to the above [1], wherein the light-emitting layer is formed by a printing method.
[7] -An organic electroluminescent element that comprises at least a first electrode layer, a light-emitting layer comprising a macromolecular compound, and a second electrode layer on a substrate, the organic electroluminescent element comprising:
   the first electrode layer provided above the substrate;
   the light-emitting layer provided above the first electrode layer;
   a charge injection layer provided above the light-emitting layer;
   a metal layer formed in a single layer and provided above the charge injection layer; and
   the second electrode layer provided above the metal layer,
   wherein the metal layer is a layer comprising a metal material selected from among aluminum, silver, tin, copper, and composite metallic materials of these metals, and wherein the second electrode layer is a layer comprising an electrode material selected from among transparent conductive oxides, transparent conductive nitrides, and composite materials of these compounds.
[8] The organic electroluminescent element according to the above [7], wherein the metal layer is formed directly on the charge injection layer provided above the light-emitting layer, and the second electrode layer is formed directly on the metal layer.
[9] The organic electroluminescent element according to the above [7], wherein the metal layer has a thickness of from 0.5 nm to 30 nm.
[10] The organic electroluminescent element according to the above [7], wherein the metal layer has a visible light transmittance of 30 % or more.
[11] The organic electroluminescent element according to the above [7], wherein the second electrode layer is a cathode that comprises one or more members selected from the group consisting of indium, tin, zinc, and aluminum.
[12] The organic electroluminescent element according to the above [7], wherein the charge injection layer comprises at least one layer among a metal layer, an inorganic layer, -and an organic layer having a work function or an ionization potential of 3.0 electron volts or less.
[13] The organic electroluminescent element according to the above [7], wherein the charge injection layer comprises one or more members selected from the group consisting of alkali metals, alkaline earth metals, alkali metal oxides, alkaline earth metal oxides, and alkali metal fluorides.

### EFFECT OF THE INVENTION

According to the present invention, a new layer can be formed by use of a simple method without substantially damaging layers previously formed, thereby increasing product yields. Particularly, when a layer made of a transparent conductive oxide, a transparent conductive nitride or the like is provided above a light-emitting layer comprising a macromolecular compound, an organic EL element can be manufactured without substantially damaging layers previously provided such as a light-emitting layer.

### BRIEF DESCRIPTION OF DRAWINGS

[Fig. 1] Fig. 1 is a schematic of an example of an embodiment of a sputtering apparatus.
[Fig. 2] Fig. 2 is a schematic of an example of an embodiment of a facing-target sputtering apparatus.
[Fig. 3] Fig. 3 is a sectional schematic of an element of a first embodiment of the present invention.
[Fig. 4] Fig. 4 is a sectional schematic of an element of a second embodiment of the present invention.
[Fig. 5] Fig. 5 is a sectional schematic of an element of a third embodiment of the present invention.

### EXPLANATIONS OF LETTERS OR NUMERALS

- 1: sputtering apparatus
- 2: gas inlet
- 3: gas outlet
- 4: container
- 5: target support
- 5a: first target support
- 5b: second target support
- 6: target
- 6a: first target
- 6b: second target
- 7: substrate directing support
- 8: element forming substrate
- 10: substrate
- 11: glass substrate
- 20: reflective electrode (first electrode layer, anode)
- 21: ITO layer (first electrode layer, anode)
- 30: hole injection layer
- 31: hole injection layer (PEDOT layer)
- 32: interlayer
- 40, 41: light-emitting layer
- 50, 51: electron injection layer
- 60, 61: metal layer
- 70: transparent electrode layer (second electrode layer, cathode)
- 71: ITO layer (second electrode layer, cathode)
- 72: reflective electrode

### BEST MODE(S) FOR CARRYING OUT THE INVENTION

Embodiments of the present invention are described below with reference to the accompanying drawings. To facilitate understanding, the scale of each member in the drawings may be different from its actual scale. The present invention is not limited by the following description. Changes and modifications can be made appropriately without departing from the spirit and scope of the present invention.

### 1. Method for manufacturing organic EL element of the present invention

The method for manufacturing an organic EL element of the present invention is a method of manufacturing an organic electroluminescent element that includes on a substrate, at least a first electrode layer, a light-emitting layer containing a macromolecular compound, and a second electrode layer. As layers that constitute the organic EL element manufactured in the present invention, a charge injection layer is provided above the light-emitting layer, and a metal layer is provided above the charge injection layer. As a general rule in this specification, a vertical positional relationship of the layers that constitute the element is described on the assumption that the substrate is provided as a bottom layer. A second layer is provided above a first layer, which means that the second layer is a layer in an upper position of the first layer, and the second layer does not necessarily directly contact the first layer. In other words, another layer may be further sandwiched between the second layer and the first layer as long as the second layer is provided at the top of the first layer. By contrast, the second layer is provided directly on the first layer, meaning that the second layer is provided on the first layer in direct contact with the first layer.

In the present specification, the first electrode layer may be an anode or a cathode. The second electrode layer may also be an anode or a cathode. When the first electrode layer is an anode, the second electrode layer is a cathode. In contrast, when the first electrode layer is a cathode, the second electrode is an anode. The charge injection layer is a hole injection layer or an electron injection layer. The charge injection layer provided at a position between the light-emitting layer and the anode is generally a hole injection layer. The charge injection layer provided at a position between the light-emitting layer and the cathode is generally an electron injection layer. In the organic EL element manufactured by the manufacturing method of the present invention, at least one charge injection layer is provided above the light-emitting layer. The organic EL element manufactured by the manufacturing method of the present invention may include other function layers such as a charge transport layer (a hole transport layer or an electron transport layer), a charge block layer (a hole block layer or an electron block layer), and a barrier layer that blocks external air, other than the first electrode layer, the light-emitting layer, the second electrode layer, the charge injection layer, and a semitransparent metal layer. A more specific embodiment of the organic EL element is described in more detail in the following "2. Organic EL element of the present invention."

In the manufacturing method of the present invention, the metal layer made of a given material is provided above the charge injection layer provided above the light-emitting layer. At a step of providing other layers such as an electrode layer above the metal layer, the metal layer has a role of protecting layers previously provided, such as the light-emitting layer, that is, layers provided as a lower layer of the metal layer. A top emission type organic EL element that radiates light from the side opposite to the substrate can be manufactured by forming a metal layer having a film thickness that allow light to be transmitted.

The metal layer is formed by using a material selected from among aluminum, silver, tin, copper, and composite metallic materials that comprise two or more members of these metals, and is more preferably formed by using aluminum or an alloy thereof.

The thickness of the metal layer is preferably from 0.5 nm to 30 nm, more preferably from 0.5 nm to 20 nm, and more preferably from 0.5 nm to 10 nm. With such a thickness, the layer readily possess the given visible light permeability. Moreover, when layers such as the second electrode layer are provided above the light-emitting layer, the charge injection layer and the like, damage to the light-emitting layer and the like due to the influence at the step of forming the layers can be sufficiently inhibited. A single layer made of such a material described above with such a thicknesses may be provided, and thus there is no need to provide multiple layers. Accordingly, the operation process can be simplified.

Examples of a forming method of the metal layer preferably may include a vacuum deposition method, and more preferably, a resistance heating method, an induction heating method, a Knudsen cell method and an electron-beam evaporation method, all of which use a boat or a crucible filled with a deposition source. The vacuum deposition method is suitable in that a layer having such a preferable thickness as described above can be formed using aluminum, silver, tin, copper, or a composite metallic material of these metals, and the layer can be formed without damaging the layers previously formed. The vacuum deposition method is a method of depositing a material to be stacked (or be formed into a film) by heating and evaporating the material and resolidifying the evaporated material on a substrate in a vacuum. In the vacuum deposition method, various kinds of heat sources are used as heat sources that vaporize materials. As one type thereof, the vacuum deposition method includes a method of using electron beams referred to as an electron-beam evaporation method. The electron-beam evaporation method enables vapor deposition of high melting point metals, oxides, nitrides, or the like to be easily performed.

In the manufacturing method of the present invention, the second electrode layer is formed using a predetermined material above the metal layer by a low damage sputtering method, a chemical vapor deposition (CVD) method, or an ion plating method.

For the low damage sputtering method, the following methods, for example, may be suitably used: a magnetron sputtering method in which a substrate holder is biased to prevent irradiation of ionized high-energy particles to a substrate; a facing-target sputtering method; or an ion beam method by which sputtering is performed by irradiating a target with ions ejected from an ion gun. Among them, examples as preferable embodiments may include a facing-target-sputtering method and an ion beam method, and more preferably a facing-target sputtering method.

The CVD method is a method of forming a film on a substrate by introducing reactant gas into a chamber and chemically reacting the reactant gas using heat, plasma, or light for the reaction. Particularly, preferable are a light CVD method and a plasma CVD method that are capable of forming a film even when the substrate temperature is low, and further preferable is a plasma CVD method because of the uniformity in film formation.

The ion plating method is a technique to activate and vapor deposit a target by irradiating the target with gas plasma generated by a plasma generator, and turning a part of evaporated particles into ions or excited particles. In this method, the plasma of reactant gas can be utilized to be bonded with evaporated particles, and a compound film can also be synthesized. Particles generated have comparatively small kinetic energy and thus have small effects on an organic layer.

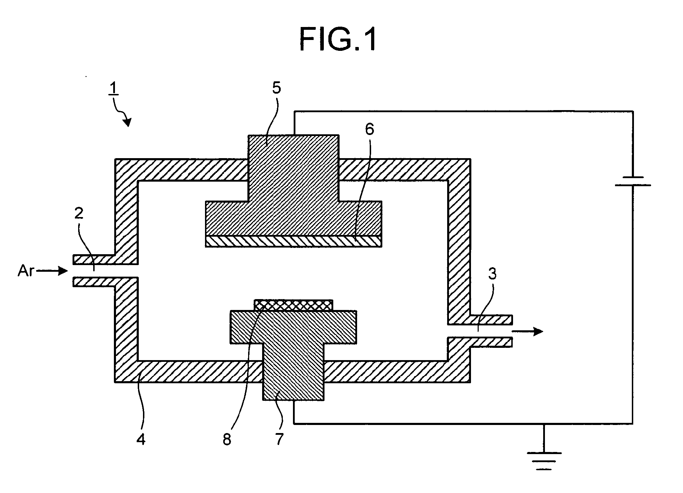

An example of a general apparatus and a method used for a sputtering method is described with reference to Fig. 1. A sputtering apparatus 1 illustrated in Fig. 1 includes a container 4 that serves as an exterior package, and a target support 5, a target material 6, a substrate support 7, and an element forming substrate 8 are equipped inside the container 4. The target material 6 is a material to be formed into a film on a substrate and is provided on the target support 5. The element forming substrate 8 is a substrate placed on the substrate support 7 for forming each layer that constitutes an organic EL element. A gas inlet 2 for injecting gas to be filled in the container is provided in the sputtering apparatus 1. Generally, argon gas is used, for example. The gas in the container 4 is exhausted from a gas outlet 3.

In the example illustrated in Fig. 1, voltage is applied to the target support 5 and the substrate support 7 to generate a magnetic field at an area between them, and positively charged argon ions are made to collide with the target material 6 to sputter the target material. Other particle generating sources such as electron beams may be used in a method of sputtering the target material. The atoms or molecules of the target material generated from the target 6 by sputtering are electrically deposited on the substrate.

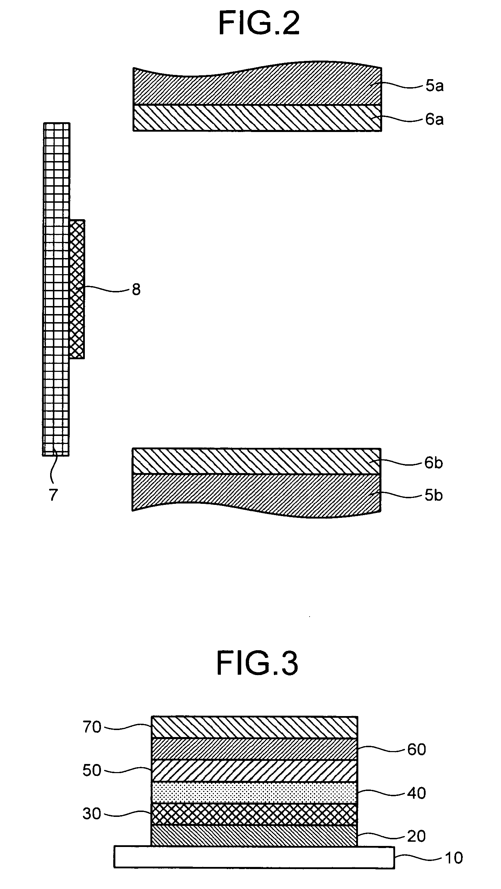

In the manufacturing method of the present invention, a facing-target sputtering method is preferably employed as a low damage sputtering method. Fig. 2 illustrates an example of an embodiment of facing-target sputtering. Fig. 2 indicates only a placement relationship between a substrate support and a target support, which is a feature of a facing-target sputtering method. The first target 6a on the first target support 5a and the second target 6b on the second target support 5b are arranged so as to face each other, and be in parallel or substantially parallel arrangement. A magnetic field is generated at an area between the first target 6a and the second target 6b, and argon ions and the like are generated from argon gas filled in the apparatus. The argon ions and the like are made to collide with the first target 6a and the second target 6b to be sputtered, and the atoms or molecules of the material included in the target (hereinafter, also referred to as a "target material") are scattered. In Fig. 2, the substrate support 7 is provided on the left side of the first and the second target supports 5a and 5b. The substrate support 7 is arranged in a vertical direction orthogonal to the planes of the first and the second target supports 5a and 5b. One plane of the substrate support 7 faces the side of the first and the second target supports 5a and 5b. The element forming substrate 8 is placed on the plane of the substrate support 7 that faces the side of the target supports. The atoms or molecules of the target material scattered by sputtering are deposited on the element forming substrate 8.

In the facing-target sputtering method, the damaging factor of high-energy particles (e.g., charged particles, accelerated neutral particles) generated by sputtering is not readily scattered in a direction toward the substrate, and layers previously formed are less likely to be damaged because collisions to the substrate occur relatively infrequently.
In the manufacturing method of the present invention, damage to the layers previously formed, and particularly to the light-emitting layer, can be significantly suppressed by a simple method of forming a single-layered metal layer with a combination of a low damage sputtering method, a CVD method, or an ion plating method and the metal layer. Particularly, when a top emission type or a double-sided light-emitting organic EL element in which a cathode is provided above the light-emitting layer is manufactured, the second electrode layer that serves as a cathode is made to be a transparent electrode layer. Preferably, for a material that forms the transparent electrode layer, for example, transparent conductive oxides or nitrides are suitable for use, and preferably, indium tin oxide (ITO), indium zinc oxide (IZO), or the like is used. Many of such materials are high melting point materials, and thus high energy is needed to be given for forming a thin film. For such a reason, when the second electrode layer is formed, the charge injection layer and the light-emitting layer that are previously formed are easily damaged. However, the manufacturing method of the present invention enables damage to the layers previously provided to be significantly suppressed by providing the metal layer in advance and then stacking an upper layer part including the second electrode layer by the facing-target sputtering method or the like. The manufacturing method of the present invention is extremely useful as a method of manufacturing a top emission type or a double-sided light-emitting organic EL element, in both of which a cathode layer is provided above the light-emitting layer.

As described above, when the second electrode layer is a cathode, one member or two or more members selected from among barium, barium oxide, strontium oxide, cesium oxide, molybdenum oxide, vanadium oxide, tungsten oxide, and tantalum oxide may be suitable for a material to form the charge injection layer above the light-emitting layer. The layers are less likely to be damaged in the manufacturing method of the present invention, even when the charge injection layer is provided at a position between the light-emitting layer and the second electrode layer using these materials, and then a transparent electrode and the like are laminated above the layers.
When the second electrode layer is an anode, molybdenum oxide or the like can be suitable for a material to form the charge injection layer above the light-emitting layer. The layers are less likely to be damaged in the manufacturing method of the present invention, even when the charge injection layer is provided at a position between the light-emitting layer and the second electrode layer using those materials, and then a transparent electrode and the like are stacked above the layers.

Forming methods of other layers are described below. An appropriate forming method of each layer may be appropriately selected from the following in view of the layer forming material, the thickness demanded, or the like described in detail below.

Examples of a forming (film-forming) method of the anode as the first electrode layer may include a vacuum deposition method, a sputtering method, an ion plating method, and a plating method. For a forming (film-forming) method of the cathode as the first electrode layer, a vacuum deposition method, a sputtering method, a CVD method, an ion plating method, a plating method, a lamination method by which a metal thin film is press-bonded, or the like is used.

The charge injection layer preferably includes at least one of a metal layer, an inorganic layer, and an organic layer having a work function or an ionization potential of equal to or less than a predetermined value. The upper limit of a work function or an ionization potential is preferably 3.0 electron volts or less, and more preferably 2.8 electron volts or less.

The electron injection layer as one type of the charge injection layer may be formed by, for example, a vapor deposition method, a sputtering method, or a printing method. Examples of a forming (film-forming) method of the hole injection layer as one type of the charge injection layer may include a vapor deposition method, a sputtering method, a spin coating method, and a printing method. The charge injection layer provided above the light-emitting layer is provided preferably by a vacuum deposition method. The vacuum deposition method is suitable in that a thin film is easily formed using a material capable of forming the charge injection layer, and that the thin film is easily stacked without damaging the light-emitting layer and the like that are previously formed.

For a low molecular hole transport material, examples of a forming (film-forming) method of the hole transport layer as one type of the charge transport layer may include a method of forming a film from a mixed solution of the hole transport material and a polymer binder. For a macromolecular hole transport material, a method of forming a film from absolution is shown as an example.

A solvent used for forming a film from the solution is not particularly limited as long as the solution dissolves the hole transport material. Examples of the solvent may include: a chlorine based solvent such as chloroform, methylene chloride, and dichloroethane; an ether based solvent such as tetrahydrofuran; an aromatic hydrocarbon based solvent such as toluene and xylene; a ketone based solvent such as acetone and methyl ethyl ketone; and an ester based solvent such as ethyl acetate, butyl acetate, or ethyl cellosolve acetate.

Examples of the available methods of forming a film from the solution may include application methods of the solution: a coating method such as a spin coating method, a casting method, a micro-gravure coating method, a gravure coating method, a bar coating method, a roll coating method, a wire bar coating method, a dip coating method, a slit coating method, a capillary coating method, a spray coating method, and a nozzle coating method; and printing methods such as a gravure printing method, a screen printing method, a flexo printing method, an offset printing method, a reverse printing method, and an inkjet printing method. The printing methods such as a gravure printing method, a screen printing method, a flexo printing method, an offset printing method, a reverse printing method, and an inkjet printing method are preferable in that pattern formation is easy.

Examples of a forming (film-forming) methods of the electron transport layer as one type of the charge transport layer may include: for a low molecular electron transport material, a vacuum deposition method using powder material, or a method of forming a film from a solution or melted material; and for a macromolecular electron transport material, a method of forming a film from a solution or melted material. For forming a film from a solution or melted material, a polymer binder may be used in combination. Examples of a method of forming a film of the electron transport layer from the solution may include film-forming methods similar to the method of forming a film of the hole transport layer from the solution described above.

For a forming (film-forming) method of a light-emitting layer that includes a macromolecular compound, a method of applying a solution including a light-emitting material onto the substrate or to the upper side of the substrate, a vacuum deposition method, a transfer method, or the like may be used. The light-emitting material in the present embodiment contains at least a macromolecular compound. The light-emitting material may also include a low molecular compound. Specific examples of a solvent used for forming a film from a solution may include a solvent similar to the solvent in which the hole transport material is dissolved when the hole transport layer is formed from the solution described above.

Examples of the available method of applying a solution including the light-emitting material onto the substrate or to the upper side of the substrate may include application methods: coating methods such as a spin coating method, a casting method, a micro-gravure coating method, a gravure coating method, a bar coating method, a roll coating method, a wire bar coating method, a dip coating method, a slit coating method, a capillary coating method, a spray coating method, and a nozzle coating method; and printing methods such as a gravure printing method, a screen printing method, a flexo printing method, an offset printing method, a reverse printing method, and an inkjet printing method. The printing methods such as a gravure printing method, a screen printing method, a flexo printing method, an offset printing method, a reverse printing method, and an inkjet printing method are preferable in that pattern formation and color-coding in multiple colors are easily performed. For a sublimable low molecular compound, a vacuum deposition method may be used. Moreover, a method of forming the light-emitting layer only on a desired area by transfer using a laser, transfer by friction, or thermal transfer may also be used.

Among them, examples of the forming method of a light-emitting layer that includes a macromolecular compound preferably may include a printing method and a spin coating method, and more preferably a printing method.

2. Organic EL element of the present invention An embodiment of the organic EL element of the present invention is described below. In the organic EL element of the present invention, a first electrode layer is provided above the substrate, a light-emitting layer is provided above the first electrode layer, a charge injection layer is provided above the light-emitting layer, a metal layer formed in a single layer is provided above the charge injection layer, and a second electrode layer is provided above the metal layer. The metal layer is made of a metal material selected from among aluminum, silver, tin, copper, and composite metallic materials of these metals. The second electrode layer is formed using an electrode material selected from among transparent conductive oxides, transparent conductive nitrides, and mixed materials of these compounds. The organic EL element of the present invention can be manufactured without any damage to the light-emitting layer and the charge injection layer provided above the light-emitting layer by the manufacturing method of the present invention. That is, the organic EL element of the present invention is designed to have a structure as described above, and thus defective products are unlikely to be produced in the manufacturing process.

Preferred materials, the layer thickness, and a forming method of the metal layer and the like are the same as those described in the section "Method for manufacturing organic EL element of the present invention." The second electrode layer formed as a transparent electrode layer or the like is also the same as that described in the section "Method for manufacturing organic EL element of the present invention". An exception is that the metal layer and the second electrode layer are provided at predetermined positions using predetermined materials as described above, the layers that constitute the organic EL element of the present invention may employ various types of layers.

The organic EL element of the present invention necessarily includes the anode, the light-emitting layer, the cathode, the metal layer, and the charge injection layer provided above the light-emitting layer. In addition to these layers, the organic EL element of the present invention may further include another layer at any one of a position between the anode and the light-emitting layer and a position between the light-emitting layer and the cathode or both.

Examples of the layers which may be provided at a position between the cathode and the light-emitting layer may include an electron injection layer, an electron transport layer, and a hole block layer. When both the electron injection layer and the electron transport layer are provided, the layer closer to the cathode is the electron injection layer, and the layer closer to the light-emitting layer is the electron transport layer.

The electrons injection layer is a layer that functions to improve electron injection efficiency from the cathode, and the electron transport layer is a layer that functions to improve electron injection from the cathode, the electron injection layer, or the electron transport layer closer to the cathode. When the electron injection layer or the electron transport layer functions to block hole transport, these layers may also serve as hole block layers.

Examples of the layers provided at a position between the anode and the light-emitting layer may include a hole injection layer, a hole transport layer, and an electron block layer. When both the hole injection layer and the hole transport layer are provided, the layer closer to the anode is the hole injection layer, and the layer closer to the light-emitting layer is the hole transport layer.

The hole injection layer is a layer that functions to improve hole injection efficiency from the anode, and the hole transport layer is a layer that functions to improve hole injection from the anode, the hole injection layer, or the hole transport layer closer to the anode. When the hole injection layer or the hole transport layer functions to block electron transport, these layers may also serve as electron block layers.

While an organic EL element 20 generally includes a single layer of the light-emitting layer, this is not limited thereto. Two or more light-emitting layers may also be provided. In this case, the two or more light-emitting layers may be directly stacked to be in contact with each other, or a charge injection layer, a charge transport layer, a charge block layer, an electrode, or the like may be appropriately inserted at a position between such layers.

More specifically, examples of the organic EL element may include any of the following layered structures.
a) substrate/anode/light-emitting layer/charge injection layer/metal layer/cathode
b) substrate/anode/charge injection layer/light-emitting layer/charge injection layer/metal layer/cathode
c) substrate/anode/hole transport layer/light-emitting layer/charge injection layer/metal layer/cathode
d) substrate/anode/charge injection layer/hole transport layer/light-emitting layer/charge injection layer/metal layer/cathode
e) substrate/anode/light-emitting layer/electron transport layer/charge injection layer/metal layer/cathode
f) substrate/anode/charge injection layer/light-emitting layer/electron transport layer/charge injection layer/metal layer/cathode
g) substrate/anode/charge injection layer/hole transport layer/light-emitting layer/charge transport layer/metal layer/cathode
h) substrate/anode/hole transport layer/light-emitting layer/electron transport layer/charge injection layer/metal layer/cathode
i) substrate/anode/charge injection layer/hole transport layer/light-emitting layer/charge transport layer/charge injection layer/metal layer/cathode (A forward slash (/) indicates that each layer is adjacently laminated. The layered structures indicate that the more to the right a layer is, the more to the upper the layer is when the substrate is provided as the lowest layer. The same meaning shall apply hereinafter.)

a') substrate/cathode/light-emitting layer/charge injection layer/metal layer/anode
b') substrate/cathode/charge injection layer/light-emitting layer/charge injection layer/metal layer/anode
c') substrate/cathode/electron transport layer/light-emitting layer/charge injection layer/metal layer/anode
d') substrate/cathode/charge injection layer/hole transport layer/light-emitting layer/charge injection layer/metal layer/anode
e') substrate/cathode/light-emitting layer/hole transport layer/charge injection layer/metal layer/anode
f') substrate/cathode/charge injection layer/light-emitting layer/hole transport layer/charge injection layer/metal layer/anode
g') substrate/cathode/charge injection layer/electron transport layer/light-emitting layer/charge transport layer/metal layer/anode
h') substrate/cathode/electron transport layer/light-emitting layer/hole transport layer/charge injection layer/metal layer/anode
i') substrate/cathode/charge injection layer/electron transport layer/light-emitting layer/charge transport layer/charge injection layer/metal layer/anode

The organic EL element may also include two or more light-emitting layers.
Examples of an organic EL elements including two light-emitting layers may include an organic EL element that has a layered structure of:
p) anode/charge injection layer/hole transport layer/light-emitting layer/charge transport layer/charge injection layer/electrode/charge injection layer/hole transport layer/light-emitting layer/electron transport layer/charge injection layer/metal layer/cathode.
Specific examples of an organic EL element including a light-emitting layer having three or more layers, in which electrode/charge injection layer/hole transport layer/light-emitting layer/electron transport layer/charge injection layer is represented by a repeating unit (hereinafter, referred to as a "repeating unit A"), may include an organic EL element that has a layered structure including two or more repeating units A of:
q) anode/charge injection layer/hole transport layer/light-emitting layer/charge transport layer/charge injection layer/repeating unit A/repeating unit A (optionally repeated)/cathode.
In the layered structures p and q, each layer other than the anode, the electrode, the cathode, and the light-emitting layers may be omitted as needed. The metal layer may be provided above the charge injection layer in each repeating unit or may be provided as only one layer at a stage before an electrode is finally provided.
An electrode is a layer that generates holes and electrons when an electric field is applied thereto. Examples of a material that constitutes the electrode may include metal oxides such as vanadium oxide, ITO, and molybdenum oxide.

In the organic EL element, all layers at either side of each light-emitting layer are generally made to be transparent to emit light from the light-emitting layer. Specifically, for example, when the organic EL element has a structure of anode/hole injection layer/hole transport layer/light-emitting layer/electron transport layer/electron injection layer/cathode, a so-called bottom emission type element can be provided by employing transparent layers for all of the anode, the hole injection layer, and the hole transport layer; or a so-called top emission type element can be provided by employing transparent layers for all of the electron transport layer, the electron injection layer, and the cathode. Moreover, when the organic EL element has a structure of cathode/electron injection layer/electron transport layer/light-emitting layer/hole transport layer/hole injection layer/anode, a so-called bottom emission type element can be provided by employing transparent layers for all of the cathode, the electron injection layer, and the electron transport layer, or a so-called top emission type element can be provided by employing transparent layers for all of the hole transport layer, the hole injection layer, the anode, and a sealing material. Transparency here indicates that the visible light transmittance from the light-emitting layer to the layer from which light is emitted is preferably 30 % or more. For an element required to emit light in the ultraviolet or infrared range, transmittance at such ranges is preferably 30 % or more.

The organic EL element may further include the charge injection layer or an insulating layer having a film thickness of 2 nm or less adjacent to the electrodes to improve adhesion to the electrodes and charge injection from the electrodes. A thin buffer layer may also be inserted in the interface of the charge transport layer and the light-emitting layer to, for example, improve adhesion at the interface or to prevent mixing. The order and the number of layers to be stacked and the thickness of each layer may be decided appropriately by taking into consideration light emitting efficiency and element life.

The material of and the forming method of each layer that constitutes the organic EL element are described more specifically below.

### <Substrate>

Any substrate is applicable to the substrate may included in the organic EL element of the present invention as long as it remains unchanged when electrodes and layers of organic substances are formed. Examples of the material used may include glass, plastic, a polymer film, a silicon substrate, a metal plate, and a laminate thereof. Moreover, plastic, a polymer film, or other material that is subjected to low permeability treatment may also be used. The substrate is commercially available or can be manufactured by a publicly known method.

### <Anode>

For the anode of the organic EL element, an electrode capable of transmitting light is preferably used because such an electrode enables the element to emit light through the anode. For such a transparent electrode, a thin film of metal oxides, metal sulphides, and metals, all of which have high electric conductivity, may be used. An electrode with high transmittance may be suitably utilized and is used by being appropriately selected depending on the organic layer used. Specifically, indium oxide; zinc oxide; tin oxide; indium tin oxide (abbreviated to ITO); indium zinc oxide (abbreviated to IZO); a metal such as gold, platinum, silver, copper, aluminum, or an alloy containing two or more members of these metals is used. Among these, ITO, IZO, and tin oxide are preferred. An organic transparent conductive film of polyaniline or a derivative thereof, polythiophene or a derivative thereof, or the like may be used as the anode.
For the anode, a material that reflects light may be used. For such material, metals, metal oxides, and metal sulphides all of which have a work function of 3.0 electron volts or more are preferred.

The film thickness of the anode may be appropriately selected in consideration of light transparency and electric conductivity and is for example, 5 nm to 10 µm, preferably 10 nm to 1 µm, and more preferably 20 nm to 500 nm.

### <Hole injection layer>

The hole injection layer can be provided at a position between the anode and the hole transport layer or between the anode and the light-emitting layer. Material for the hole injection layer that constitutes the hole injection layer is not particularly limited, and a publicly known material may be appropriately used. Examples of the material may include: phenylamines; starburst amines; phthalocyanines; a hydrazone derivative; a carbazole derivative; a triazole derivative; an imidazole derivative; an oxadiazol derivative having an amino group; oxides such as vanadium oxide, tantalum oxide, tungsten oxide, molybdenum oxide, ruthenium oxide, and aluminum oxide; amorphous carbon; polyaniline; and a polythiophene derivative. The thickness of such a hole injection layer is preferably about 5 nm to 300 nm. A thickness less than the lower limit tends to make manufacture difficult. On the other hand, a thickness exceeding the upper limit tends to increase the driving voltage and voltage applied to the hole injection layer.

### <Hole transport layer>

Material for the hole transport layer that constitutes the hole transport layer is not particularly limited, and examples of the material may include: aromatic amine derivatives such as N,N'-diphenyl-N,N'-di (3-methylphenyl)4,4'-diaminobiphenyl (TPD) and NPB (4,4'-bis[N-(1-naphthyl)-N-phenylamino]biphenyl), polyvinyl carbazole or a derivative thereof, polysilane or a derivative thereof, a polysiloxane derivative having an aromatic amine at the side chain or the main chain, a pyrazoline derivative, an arylamine derivative, a stilbene derivative, a triphenyl diamine derivative, polyaniline or a derivative thereof, polythiophene or a derivative thereof, polyarylamine or a derivative thereof, polypyrrole or a derivative thereof, poly(p-phenylene vinylene) or a derivative thereof, or poly(2,5-thienylene vinylene) or a derivative thereof.

Among these, the hole transport material used for the hole transport layer is preferably a macromolecular hole transport material such as polyvinyl carbazole or a derivative thereof, polysilane or a derivative thereof, a polysiloxane derivative having an aromatic amine compound group at the side chain or the main chain, polyaniline or a derivative thereof, polythiophene or a derivative thereof, polyarylamine or a derivative thereof, poly(p-phenylene vinylene) or a derivative thereof, or poly(2,5-thienylene vinylene) or a derivative thereof, and more preferably, polyvinyl carbazole or a derivative thereof, polysilane or a derivative thereof, or a polysiloxane derivative having an aromatic amine at the side chain or the main chain. When a low molecular hole transport material is used, the material is preferably dispersed in a polymer binder.

A binder that does not extremely inhibit charge transportation is preferable for a mixed polymer binder, and a binder that does not have strong absorption of visible light is suitable for use. Examples of the polymer binder may include polycarbonate, polyacrylate, polymethyl acrylate, polymethyl methacrylate, polystyrene, polyvinyl chloride, and polysiloxane.

The optimal value for the film thickness of the hole transport layer varies depending on the material used. Although the film thickness may be selected to have appropriate values of driving voltage and light-emitting efficiency, at least a thickness with which no pinhole is formed is required. When the thickness is excessively large, the driving voltage of the element may increase, which is not preferable. Accordingly, the film thickness of the hole transport layer is, for example, 1 nm to 1 µm, preferably 2 nm to 500 nm, and more preferably 5 nm to 200 nm.

### <Light-emitting layer>

In the present invention, the light-emitting layer is preferably an organic light-emitting layer and generally contains an organic substance that mainly emits fluorescence or phosphorescence. The light-emitting layer may further include a dopant material. Examples of a material that forms the light-emitting layer capable of being used in the present invention include the following pigment materials, metal complex materials, macromolecular materials, and dopant materials.

### [Pigment materials]

Examples of the pigment materials may include a cyclopendamine derivative, a tetraphenyl butadiene derivative compound, a triphenyl amine derivative, an oxadiazole derivative, a pyrazoloquinoline derivative, a distyrylbenzene derivative, a distyrylarylene derivative, a pyrrole derivative, a thiophene ring compound, a pyridine ring compound, a perynone derivative, a perylene derivative, an oligothiophene derivative, an oxadiazole dimmer, and a pyrazoline dimmer.

### [Metal complex materials]

Examples of the metal complex materials may include: metal complexes such as an iridium complex and a platinum complex that emit light from the triplet excited state; and a metal complex that has a central metal of Al, Zn, Be, or a rare earth metal such as Tb, Eu, or Dy, and that has a structure of oxadiazole, thiadiazole, phenylpyridine, phenylbenzimidazole, quinoline; or the like as a ligand, such as an alumiquinolinol complex, a benzoquinolinole beryllium complex, a benzoxazolyl zinc complex, a benzothiazole zinc complex, an azomethyl zinc complex, a porphyrin zinc complex, or an europium complex.

### [macromolecular materials]

Examples of the macromolecular materials may include a polyparaphenylene vinylene derivative, a polythiophene derivative, a polyparaphenylene derivative, a polysilane derivative, a polyacetylene derivative, a polyfluorene derivative, a polyvinyl carbazole derivative, and a material in which any of the pigments or the metal complex light-emitting materials are made into macromolecules.
Among the light-emitting materials, examples of material that emits blue light may include: a distyrylarylene derivative, an oxadiazole derivative, and their polymers; a polyvinyl carbazole derivative; a polyparaphenylene derivative; and a polyfluorene derivative. Among these, macromolecular materials such as a polyvinyl carbazole derivative, a polyparaphenylene derivative, and a polyfluorene derivative are preferred.
Examples of material that emits green light may include: a quinacridone derivative, a coumarin derivative, and their polymers; a polyparaphenylene vinylene derivative; and a polyfluorene derivative. Among these, polymer materials such as a polyparaphenylene vinylene derivative, and a polyfluorene derivative are preferred.
Examples of material that emits red light may include: a coumarin derivative, a thiophene ring compound, and their polymers; a polyparaphenylene vinylene derivative; a polythiophene derivative, and a polyfluorene derivative. Among these, macromolecular materials such as a polyparaphenylene vinylene derivative, a polythiophene derivative, and a polyfluorene derivative are preferred.

Among the materials described above, the blue materials are prone to be damaged during the process of forming other layers. Therefore, when blue materials are used as the macromolecular light-emitting materials, the manufacturing method of the present invention is particularly suitably employed.

### [Dopant materials]

A dopant may be added into the light-emitting layer to, for example, improve the light-emitting efficiency or to change a light-emitting wavelength. Examples of such a dopant may include a perylene derivative, a coumarin derivative, a rubrene derivative, a quinacridone derivative, a squarylium derivative, a porphyrin derivative, a styryl pigment, a tetracene derivative, a pyrazolone derivative, decacyclene, and phenoxazon. The thickness of such a light-emitting layer is generally about 2 nm to 2000 nm.

### [Electron transport layer]

A publicly known material may be used as a material that constitutes the electron transport layer. Examples of the material may include an oxadiazole derivative, anthraquinodimethane or a derivative thereof, benzoquinone or a derivative thereof, naphthoquinone or a derivative thereof, anthraquinone or a derivative the tetracyanoanthraquinodimethane or a derivative thereof, a fluorenone derivative, diphenyldicyanoethylene or a derivative thereof, a diphenoquinone derivative, a metal complex of 8-hydroxyquinoline or of a derivative of 8-hydroxyquinoline, polyquinoline or a derivative thereof, polyquinoxaline or a derivative thereof, and polyfluorene or a derivative thereof.

Among these, an oxadiazole derivative, benzoquinone or a derivative thereof, anthraquinone or a derivative thereof, 8-hydroxyquinoline or a metal complex of a 8-hydroxyquinoline derivative, polyquinolino or a derivative thereof, polyquinoxaline or a derivative thereof, and polyfluorene or a derivative thereof are preferred, and 2-(4-biphenylyl)-5-(4-t-butylphenyl)-1,3,4-oxadiazole, benzoquinone, anthraquinone, tris(8-quinolinol)aluminum, and polyquinoline are further preferred.

The optimal value for the film thickness of the electron transport layer varies depending on the material used. Although the film thickness may be selected to have appropriate values of driving voltage and light-emitting efficiency, at least a thickness with which no pinhole is formed is required. When the thickness is excessively large, the driving voltage of the element may increase, which is not preferable. Accordingly, the film thickness of the electron transport layer is, for example, 1 nm to 1 µm, preferably 2 nm to 500 nm, and more preferably 5 nm to 200 nm.

### [Electron injection layer]

The electron injection layer is provided at a position between the electron transport layer and the cathode or between the light-emitting layer and the cathode. Examples of the electron injection layer may include: depending on the type of the light-emitting layer, alkali metals and alkaline-earth metals; alloys that contain one or more members of the metals; oxides, halides and carbonates of the metals; or a mixture of these compounds. Examples of the alkali metals or the oxides, halides, and carbonates of the alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals or the oxides, halides, and carbonates of the alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. Moreover, an organic metal compound doped with a metal, a metal oxide, or a metal salt, an organic metal complex compound, or a mixture thereof may also be used as the electron injection layer. The electron injection layer may also be a laminate of two or more layers. Specific examples may include LiF/Ca. The film thickness of the electron injection layer is preferably about 1 nm to 1 µm.
As a preferable embodiment, the electron injection layer may be constituted with a material having an ionization potential or a work function that is close to the lowest unoccupied molecular orbital (LUMO) level of the electron transport layer or the light-emitting layer. Accordingly, as a preferable embodiment, the electron injection layer includes at least one layer out of a metal layer, an inorganic layer, and an organic layer having a work function or an ionization potential of preferably 3.0 electron volts or more, and more preferably 2.8 electron volts or more. An embodiment constituted with such a material, for example, a material having a work function close to the LUMO level, such as Ba and BaO, is available.

### <Cathode>

Examples of the material for the cathode used in the organic EL element may include a material having a small work function and facilitating electron injection into the light-emitting layer, a material having high electric conductivity, a material having high visible light reflectance, and a material having two or more members of these properties. As metals, for example, an alkali metal, an alkaline-earth metal, a transition metal, or a group 13 metal may be used. Examples of the metals available may include: metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium, gold, silver, platinum, copper, manganese, titanium, cobalt, nickel, tungsten, and tin; alloys of two or more of the metals; or graphite or a graphite interlayer compound. Examples of the alloys may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. For the cathode, a transparent conductive electrode may be used, for example, a conductive metal oxide or a conductive organic substance may be used. Specifically, indium oxide, zinc oxide, tin oxide, and as complexes thereof, ITO and IZO may be used as the conductive metal oxide, and an organic transparent conductive film of polyaniline or a derivative thereof, polythiophene or a derivative thereof, or the like may be used as the conductive organic substance. The cathode may be in a layered structure having two or more layers. The electron injection layer may be used as the cathode. For a method for manufacturing the cathode, a vacuum deposition method, a sputtering method, a CVD method, an ion plating method, a laser ablation method, or a lamination method by which a metal thin film is press-bonded, for example, is used.

Although the film thickness of the cathode may be appropriately selected in consideration of electric conduct and durability, the film thickness is, for example, 10 nm to 10 µm, preferably 20 nm to 1 µm, and more preferably 50 nm to 500 nm.

A more specific embodiment of the organic EL element of the present invention is described with reference to Figs. 3 to 5. Fig. 3 illustrates a first embodiment of the organic EL element of the present invention (hereinafter, also referred to as an "element of the first embodiment"). The element of the first embodiment includes a reflective electrode 20 (first electrode layer), a hole injection layer 30, a light-emitting layer 40, an electron injection layer 50, a metal layer 60, a transparent electrode layer 70 (second electrode layer), all of which are stacked on a substrate 10 in this order. In the element of the first embodiment, the reflective electrode 20 is an anode and the transparent electrode layer 70 is a cathode. In the element of the first embodiment, a metal layer is formed in a single layer made of aluminum. The reflective electrode 20 is formed in a stacked structure of ITO/Ag/ITO. For the second electrode layer, the transparent electrode layer 70 made of ITO is employed. In other words, the element of the first embodiment is a top emission type element. One layer of the metal layer is provided directly on the electron injection layer 50, and therefore even when a transparent electrode layer made of ITO is further formed on the metal layer, the light-emitting layer 40 and the electron injection layer 50 are not substantially damaged, thus constructing an organic EL element with excellent propertied such as brightness.

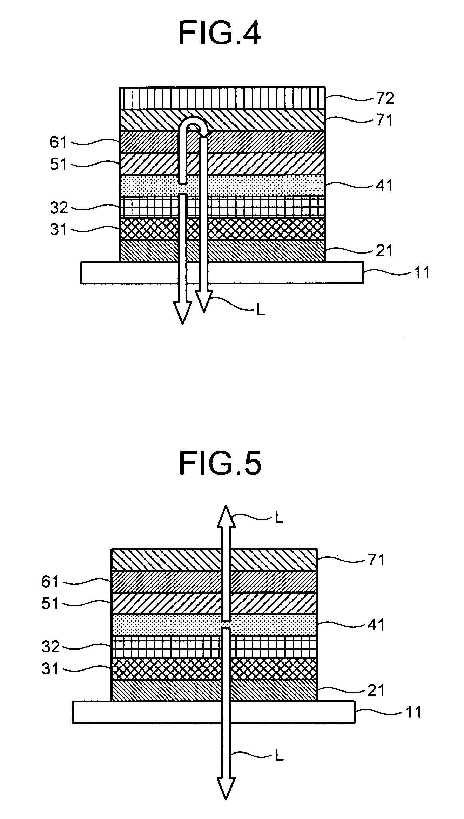

Fig. 4 illustrates an element of a second embodiment. The element of the second embodiment is a bottom emission type element that emits light L from the sie of a glass substrate 11. The element of the second embodiment includes an ITO layer 21 (first electrode layer), a hole injection layer 31 made of a macromolecular material that contains PEDOT (polyethylenedioxythiophene) as the main component, an interlayer 32, a light-emitting layer 41, an electron injection layer 51, a metal layer 61, an ITO layer 71 (second electrode layer), and a reflective electrode 72, all of which are stacked on the glass substrate 11 in this order. In the element of the second embodiment, the ITO layer 21 is an anode and the ITO layer 71 is a cathode. The reflective electrode 72 made of aluminum is provided directly on the ITO layer 71 to extract the light L emitted from the light-emitting layer 41, from the side of the glass substrate 11. An interlayer is provided as an electron block layer. Although ITO is provided at the upper side of the light-emitting layer 41 also in this embodiment, the film formation of the ITO does not substantially damage the light-emitting layer 41, thus constructing an organic EL element with excellent properties such as brightness.

Fig. 5 illustrates an element of a third embodiment. The element of the third embodiment has a structure in which the reflective electrode 72 is removed from the element of the second embodiment. Accordingly, the light L can be extracted also from the side of the ITO layer 71 serving as a cathode, and thus the element of the third embodiment is a double-sided light-emitting element. For the rest, the element of the third embodiment is the same as the element of the second embodiment.

In the first to the third embodiment, the organic EL element includes terminals or the like (not illustrated in Figs. 3 to 5) to establish electric connections with other electronic equipment members. In addition, the organic EL element may be sealed by providing a sealing substrate to cover the whole of the multilayered body that includes the light-emitting layer formed on the substrate. The organic EL element of the present-invention can be used for, for example, a planar light source, a segment display device, a dot-matrix display device, or the backlight of a liquid crystal display device. The method for manufacturing the organic EL element of the present invention can inhibit damage to the organic layer and can form the electrodes and the charge injection layer in a short time. Therefore, the method for manufacturing the organic EL element of the present invention is also applicable to the formation of any one of an electrode and a charge injection layer or both when a transistor employing an organic semiconductor is manufactured.

For example, a plane anode and a plane cathode may be disposed to overlap with each other so as to emit plane light using the organic EL element of the present invention. Examples of a method of emitting patterned light may include a method of setting a mask having a patterned hole on the surface of the plane light-emitting element; a method of forming an organic layer at a nonlight-emitting portion to be extremely thick so as not to substantially emit light; and a method of forming any one of an anode and a cathode or both electrodes in a patterned shape. A pattern is formed using any of these methods and is arranged to enable several electrodes to be independently ON/OFF, and thus, a segment display device that can display numerals, letters, simple symbols, and the like can be produced. A substrate for a passive matrix in which both the anode and the cathode are formed in stripe shapes and arranged to be orthogonal to each other, or a substrate for an active matrix that performs control pixel by pixel, in which a thin film transistor is arranged, to produce a dot-matrix device. Partial color display and multicolor display are possible by a method of applying light-emitting materials having different luminous colors separately, or a method of using color filters or fluorescence conversion filters. These display elements can be used for a display device of a computer, a television, a mobile terminal, a portable cellular phone, a car navigation device, a viewfinder of a video camera, or the like.

Moreover, the plane light-emitting device is a self light-emitting thin type and can be suitable for use in a plane light source for the backlight of a liquid crystal display device or a plane illuminating light source. When a flexible substrate is used, the plane light-emitting device can also be used for a curved plane light source and a curved plane display device.

### Examples

### <Synthetic Example of polymer compound 1>

A polymer compound 1 to be the electron block layer was synthesized. Into a separable flask that had a stirring blade, a baffle, a length adjustable nitrogen introducing pipe, a cooling pipe, and a thermometer, 158.29 parts by weight of 2,7-bis(1,3,2-dioxaborolane-2-yl)-9,9-dioctylfluorene, 136.11 parts by weight of bis-(4-bromophenyl)-4-(1-methylpropyl)-benzenamine, 27 parts by weight of tricaprylmethylammonium chloride (Aliquat 336; manufactured by Henkel Corporation), and 1800 parts by weight of toluene were charged, and the mixture was heated to 90 degrees Celsius under agitation while nitrogen was introduced through the nitrogen introducing pipe. To the resultant mixture, 0.006 parts by weight of Palladium (II) diacetate and 045 parts by weight of tri(o-toluyl)phosphine were added, and then 573 parts by weight of 17.5 percent sodium carbonate aqueous solution was dropped over 1 hour. After the completion of the drop, the nitrogen introducing pipe was pulled away from the liquid surface, and the resultant mixture was kept warm under reflux for 7 hours. Subsequently, 3.6 parts by weight of phenylboric acid was added to the mixture, and the resultant mixture was kept warm under reflux for 14 hours and cooled down to room temperature. The water phase of the reaction solution was removed, and then the oil phase of the reaction solution was diluted with toluene, and was washed with 3 percent acetic acid aqueous solution and ion-exchanged water. To the separated oil phase, 13 parts by weight of N,N-diethylcarbamodithioic acid sodium 3-hydrate was added and the mixture was stirred for 4 hours and then was passed through a mixed column of activated alumina and silica gel, and toluene was passed through the column to wash the column. Filtrate and wash liquid were mixed, and then the mixture was dropped into methanol to precipitate a polymer. The obtained polymer precipitation was filtered off, the precipitation was washed with methanol, and then the polymer was dried with a vacuum dryer to produce 192 parts by weight of the polymer. The obtained polymer was called the polymer compound 1. The weight average molecular weight of and the number average molecular weight of the polymer compound. 1 in terms of polystyrene were 3.7×10⁵ and 8.9×10⁴, respectively.

### (GPC analysis)

The weight average molecular weight and the number average molecular weight in terms of polystyrene were measured by GPC. A standard polystyrene manufactured by Polymer laboratories was used to prepare the calibration curve for GPC. The polymer to be measured was dissolved in tetranydrofuran to attain a concentration of about 0.02 percent by weight, and 10 microliters of the resultant solution was injected into GPC.

The GPC apparatus used was an LC-10ADvp manufactured by Shimadzu Corporation. For the column, two PLgel 10 µm MIXED-B columns (300x7.5 millimeters) manufactured by Polymer Laboratories were connected in series, and tetrahydrofuran was passed through the columns as a mobile phase at 25 degrees Celsius at a flow speed of 1.0 mL/min. For a detector, an UV detector was used to measure absorbance at 228 nm.

### <Example 1>

### [Element manufacture]

A suspension of poly(3,4)ethylenedioxythiophene/polystyrene sulfonic acid (trade name: Baytron P/Tp AI 4083, manufactured by H.C. Starck-V TECH Ltd.) was filtered through a filter of 0.5 micrometer diameter. The filtrate was applied by a spin coating method on a glass substrate on which an ITO layer (anode) having a film thickness of about 150 nm was formed and patterned by a sputtering method to form a film having a thickness of 60 nm. Subsequently, the film-formed portion at a lead-out electrode portion and in a sealing area was wiped off, and the resultant substrate was dried in the atmosphere at about 200 degrees Celsius for 10 minutes using a hot plate.

A film of the polymer compound 1 (a film thickness of 20 nm) was formed on the substrate by a spin coating method, thus forming an electron block layer. The electron block layer at the lead-out electrode portion and in the sealing area was removed, and the resultant substrate was baked in nitrogen at 200 degrees Celsius for 20 minutes using a hot plate. Subsequently, a film of a macromolecular light-emitting organic material (BP361 manufactured by Sumation Co. Ltd.) (a film thickness of 70 nm) was formed by a spin coating method, thus forming a light-emitting layer. The light-emitting layer at the lead-out electrode portion and in the sealing area was removed, and the resultant substrate was introduced in a vacuum chamber and was moved into a heating chamber. At the following steps, processes were performed under vacuum or in nitrogen, and thus the element was never exposed to the atmosphere during the processes. The substrate was heated under vacuum at a substrate temperature of about 100 degrees Celsius for 60 minutes. Subsequently, the substrate was moved into a deposition chamber and was aligned with a cathode metal mask, and a cathode was vapor deposited with the mask and the substrate being rotated to form a film of the cathode on a light-emitting portion and the lead-out electrode portion. The degree of vacuum in the chamber before the deposition was 3×10⁻⁵ pascals or less.

Metal barium was heated by a resistance heating method and was vapor deposited at a deposition rate of about 2 angstroms/sec (0.2 nm/sec) to form an electron injection layer having a film thickness of 5 nm.

Subsequently, a metal layer was vapor deposited by evaporating Al by an electron-beam evaporation method at a deposition rate of about 2 angstroms/sec (0.2 nm/sec). An element that includes the metal layer having a film thickness of 10 nm and an element that includes the metal layer having a film thickness of 15 nm were manufactured.

As a transparent electrode layer (cathode), a film of ITO was formed using a facing-target magnetron sputtering apparatus (manufactured by FTS Corporation) to be about 160 nm. The film-forming pressure was 0.5 pascal, the power was 1000 watts, the Ar flow rate was 40 sccm, the O₂ flow rate was 2 sccm, the transfer speed was 160 mm/min, and the formed film was transferred six times. Moreover, Al was vapor deposited on the ITO layer by an electron-beam evaporation method as a reflective electrode to extract light from one side for evaluation. Al was vapor deposited at a deposition speed of about 2 angstroms/sec (0.2 nm/sec) to have a film thickness of 1000 angstroms (100 nm). Subsequently, the resultant substrate was bonded with a sealing glass to which a UV curable resin prepared in advance was applied at the peripheral, under reduced pressure in inert gas. The pressure was returned to atmospheric pressure, and the UV curable resin was irradiated with UV to be photo-cured and immobilized to manufacture a macromolecular organic EL element. The manufactured organic EL elements have the same layered structure as that of the bottom emission type element illustrated in Fig. 4. When the film of Al directly on the ITO is not formed, light is emitted from both directions of the substrate side and the cathode side, whereby a double-sided light-emitting element is manufactured. Alternatively, when a reflective metal is formed at the lower side of or the upper side of the ITO anode, and the film of Al directly on the ITO is not formed, light is emitted from the cathode side, whereby a top emission type element is manufactured. A light-emitting area in one pixel was 2x2 millimeters.
(Element structure: glass substrate/ITO (150 nm)/PEDOT (AI-4083)/IL7/SCB670/Ba (5 nm)/metal layer (Al: 10 nm, 15 nm)/ITO (160 nm) /Al (100 nm)/glass sealing)

### [Element evaluation]

Voltage was applied to the manufactured elements to measure a current-voltage property and light-emitting brightness. Light to be measured is the total light directly emitted on the glass substrate side and light emitted on the side opposite to the glass substrate (light that transmitted the ITO layer and was reflected by the Al layer serving as a reflective electrode), which is the light generated from the light-emitting layer. Therefore, the brightness (EL intensity) decreases when forming a film of ITO damages the light-emitting layer. The results are given in Table 1. As indicated in Table 1, the brightness of the elements of Example 1 did not decrease, and it was confirmed that their light-emitting layers were not damaged.

### <Comparative Example 1>

### [Element manufacture]

An element was manufactured in the same manner as in Example 1 except that a metal layer was not inserted. (Element structure: glass substrate/ITO (150 nm)/PEDOT (AI-4083)/IL7/SCB670/Ba (5 nm)/ITO (160 nm)/Al (100 nm)/glass sealing)

### [Element evaluation]

The manufactured element was measured in the same manner as in Example 1. The results are given in Table 1. As indicated in Table 1, the element of Comparative Example 1 did not even substantially emit light, and thus the light-emitting layer was assumed to be damaged.

**[Table 1]**

| | Al FILM THICKNESS (nm) | APPLIED VOLTAGE (V) | CURRENT DENSITY (A/cm²) | BRIGHTNESS (cd/m²) | CURRENT EFFICIENCY (cd/A) | ELECTRIC POWER EFFICIENCY (cd/A) |
|---|---|---|---|---|---|---|
| EXAMPLE 1 | 15 | 12 | 0.6240 | 18804.38 | 3.01 | 0.79 |
| | 10 | 12 | 0.6350 | 18508.49 | 2.91 | 0.76 |
| COMPARATIVE EXEMPLE 1 | 0 | 12 | 0.0155 | 1.93 | <0.1 | <0.1 |

### <Example 2>

### [Element manufacture]

When the reflective electrode Al is not formed, an element through which light is transmitted and that emits light from both surfaces is manufactured. Moreover, when the electrode at the glass substrate side is formed to be a reflective electrode, a top emission type element is manufactured. As a metal layer, Al was vapor deposited by an electron-beam evaporation method at a deposition rate of about 2 angstroms/sec (0.2 nm/sec) to manufacture an element that includes the metal layer having a film thickness of 5 nm. The element of Example 2 was manufactured in the same manner as in Example 1 except that the film thickness of the metal layer was 5 nm and the reflective electrode was not formed.

### [Element evaluation]

The manufactured element was measured in the same manner as in Example 1. The reflective electrode was not formed, and thus light is emitted from both surfaces on the glass substrate side and the side opposite to the glass substrate. The results are given in Table 2. As indicated in Table 2, the brightness of the element of Example 2 did not decrease, and it was confirmed that the light-emitting layer was not damaged. There was a time interval between the measurement of light extracted on the glass substrate side and the measurement of light extracted on the side opposite to the glass substrate side, and thus current densities differed even at the same applied voltages.

**[Table 2]**

| | AI FILM THICKNESS (nm) | APPLIED VOLTAGE (V) | CURRENT DENSITY (A/cm²) | BRIGHTNESS (cd/m²) | CURRENT EFFICIENCY (cd/A) | ELECTRIC POWER EFFICIENCY (cd/A) | MEASURED |
|---|---|---|---|---|---|---|---|
| EXAMPLE 2 | 5 | 12 | 4.06E-01 | 6203.67 | 1.53 | 0.4 | GLASS SUBSTRATE SIDE |
| | 5 | 12 | 4.87E-01 | 1792.83 | 0.37 | 0.096 | OPPOSITE SIDE |

### INDUSTRIAL APPLICABILITY

As described above, the present invention is useful in an industrial field related to organic EL devices.

## Claims

1. A method for manufacturing an organic electroluminescent element in which at least a first electrode layer, a light-emitting layer comprising a macromolecular organic compound, and a second electrode layer are stacked on a substrate, the method comprising the steps of:
forming the first electrode layer above the substrate;
forming the light-emitting layer above the first electrode layer;
forming a charge injection layer above the light-emitting layer;
forming a metal layer comprising a material selected from the group consisting of aluminum, silver, tin, copper, and composite metallic materials comprising two or more members of these metals above the charge injection layer; and
forming the second electrode layer by stacking an electrode material selected from among transparent conductive oxides, transparent conductive nitrides, and composite materials of these compounds above the metal layer by a low damage sputtering method, an ion plating method, or a chemical vapor deposition (CVD) method.

2. The method for manufacturing an organic electroluminescent element according to claim 1, wherein the metal layer is formed directly on the charge injection layer provided above the light-emitting layer, and the second electrode layer is formed directly on the metal layer.

3. The method for manufacturing an organic electroluminescent element according to claim 1, wherein the metal layer is formed to have a thickness of from 0.5 nm to 30 nm.

4. The method for manufacturing an organic electroluminescent element according to claim 1, wherein the metal layer is formed by a vacuum deposition method.

5. The method for manufacturing an organic electroluminescent element according to claim 1, wherein the low damage sputtering method is a facing-target sputtering method or an ion beam sputtering method.

6. The method for manufacturing an organic electroluminescent element according to claim 1, wherein the light-emitting layer is formed by a printing method.

7. An organic electroluminescent element that comprises at least a first electrode layer, a light-emitting layer comprising a macromolecular compound, and a second electrode layer on a substrate, the organic electroluminescent element comprising:
the first electrode layer provided above the substrate;
the light-emitting layer provided above the first electrode layer;
a charge injection layer provided above the light-emitting layer;
a metal layer formed in a single layer and above the charge injection layer; and
the second electrode layer provided above the metal layer,
wherein the metal layer is a layer comprising a metal material selected from among aluminum, silver, tin, copper, and composite metallic materials of these metals, and
wherein the second electrode layer is a layer comprising an electrode material selected from among transparent conductive oxides, transparent conductive nitrides, and composite materials of these compounds.

8. The organic electroluminescent element according to claim 7, wherein the metal layer is formed directly on the charge injection layer provided above the light-emitting layer, and the second electrode layer is formed directly on the metal layer.

9. The organic electroluminescent element according to claim 7, wherein the metal layer has a thickness of from 0.5 nm to 30 nm.

10. The organic electroluminescent element according to claim 7, wherein the metal layer has a visible light transmittance of 30% or more.

11. The organic electroluminescent element according to claim 7, wherein the second electrode layer is a cathode that comprises one or more members selected from the group consisting of indium, tin, zinc, and aluminum.

12. The organic electroluminescent element according to claim 7, wherein the charge injection layer comprises at least one layer among a metal layer, an inorganic layer, and an organic layer having a work function or an ionization potential of 3.0 electron volts or more.

13. The organic electroluminescent element according to claim 7, wherein the charge injection layer comprises one or more members selected from the group consisting of alkali metals, alkaline metal earth metals, alkali metal oxides, alkaline earth metal oxides, and alkali metal fluorides.
